# EUROPÄISCHE PATENTANMELDUNG

(11) **EP 1 418 645 A1**
(43) Veröffentlichungstag der Anmeldung: **12.05.2004**
(21) Anmeldenummer: 03021188.2
(22) Anmeldetag: 25.09.2003
(51) Int. Cl.: H01R 12/04, H01R 12/18

(54) **Steckerelement und Platinenaufbau**

(30) Priorität: 06.11.2002 DE 10251615
(71) Anmelder: Valeo Schalter und Sensoren GmbH, 74321 Bietigheim-Bissingen (DE)
(72) Erfinder: Biehlman, Bernd, 71638 Ludwigsburg (DE); Walz, Dirk, 72654 Neckartenzlingen (DE); Künzler, Frank, 76703 Kraichtal (DE); Papinzer, Uwe, 71739 Oberriexingen (DE)
(74) Vertreter: Dreiss, Fuhlendorf, Steimle & Becker

(57) **Zusammenfassung**

Die Erfindung betrifft ein Steckerelement, insbesondere zur Verbindung von Leiterbahnen wenigstens zweier elektrische und/oder elektronische Bauteile aufweisenden Platinen, und einen Platinenaufbau. Das erfindungsgemäße Steckerelement zeichnet sich dadurch aus, dass es als Steckerleiterplatte ausgebildet ist, die an wenigstens einer Seite einstückig mit der Steckerleiterplatte ausgebildete Kontaktzungen aufweist.

## Beschreibung

Die Erfindung betrifft ein Steckerelement, insbesondere zur Verbindung von Leiterbahnen wenigstens zweier elektrische und/oder elektronische Bauteile aufweisenden Platinen. Die Erfindung betrifft außerdem einen Platinen-Aufbau der wenigstens zwei Platinen und ein die Platinen miteinander verbindendes Steckerelement umfasst.

Aus dem Stand der Technik sind Steckerelemente zur Verbindung von Leiterbahnen von Platinen bekannt, die Steckerpins umfassen, die mit einer Kunststoff-Spritzguss-Isolierung versehen sind. Die Kunststoff-Spritzguss-Isolierung ist hierbei so ausgebildet, dass sie eine Steckereinheit bildet. Eine derartige Steckereinheit kann mit auf der entsprechenden Platine vorgesehenen Steckkontakten elektrisch leitend verbunden werden.

Nachteil derartiger Steckerelemente ist, dass sie in ihrer Herstellung sehr aufwändig sind. Zur Realisierung der Kunststoff-Spritzguss-Isolierung sind entsprechende Spritzguss-Einheiten mit zugehörigen Formen erforderlich. Der Spritzgussprozess ist aufwändig und teuer, außerdem ist eine aufwändige Technik zum Einlegen und Ablängen der die Stecker-Pins bildenden Drähte erforderlich.

Der vorliegenden Erfindung liegt deshalb die Aufgabe zugrunde, ein Steckerelement bereitzustellen, das einfach und mit wenig Aufwand herzustellen ist. Das Steckerelement soll zudem nicht größer bauen als bekannte Steckerelemente.

Diese Aufgabe wird durch ein Steckerelement gelöst, das sich dadurch kennzeichnet, dass das Steckerelement als Steckerleiterplatte ausgebildet ist, die an wenigstens einer Seite einstückig mit der Steckerleiterplatte ausgebildete Kontaktzungen aufweist. Die Kontaktzungen, die aus Steckerleiterplattenmaterial ausgebildet sind, übernehmen hierbei die Funktion der Steckerpins der bekannten Steckerelemente. Die entsprechend ausgebildeten Kontaktzungen werden bei der Montage des Steckerelements mit entsprechenden an den Platinen vorgesehenen Steckeraufnahmen versteckt. Die Steckerleiterplatte weist hierbei geeignete Kontaktbahnen auf, die in den jeweiligen Kontaktzungen enden.

Ein derartiges Steckerelement hat den Vorteil, dass es aus an sich bekannten Leiterplatten mit wenig Aufwand herstellbar ist. Insbesondere entfällt der aufwändige und kostenintensive Spritzgussprozess, der bei vorbekannten Steckerelementen erforderlich ist. Da erfindungsgemäß als Steckerelement eine Steckerleiterplatte Verwendung findet, baut das erfindungsgemäße Steckerelement gegenüber bekannten Steckerelementen sehr flach. Damit einher geht eine Bauraumersparnis.

Die Kontaktzungen können beispielsweise verzinnt sein, wobei das Lötzinn als Beschichtung der Kontaktzungen auf der Steckerleiterplatte bereits bei der Herstellung des Steckerelements aufgebacht werden kann.

Vorteilhafterweise liegen die Kontaktzungen in der Ebene der Steckerleiterplatte. Damit ergibt sich ein insgesamt sehr flach bauendes Steckerelement.

Die Kontaktzungen sind vorteilhafterweise zylindrisch ausgebildet. Das heißt, sie weisen in axialer Richtung einen konstanten Querschnitt auf. Vorzugsweise ist ein derartiger Querschnitt rechteckig ausgebildet, wobei die Höhe des Rechtecks dann vorzugsweise der Dicke der Steckerleiterplatte entspricht. Selbstverständlich sind erfindungsgemäß auch andere Querschnitte, beispielsweise runde oder ovale Querschnitte, denkbar.

Eine vorteilhafte Steckerleiterplatte ergibt sich dann, wenn die Steckerleiterplatte an zwei gegenüberliegenden Seiten Kontaktzungen aufweist. Mit einem derartigen Steckerelement können insbesondere zwei Platinen übereinander verbaut werden, wobei zwischen den beiden Platinen das Steckerelement angeordnet ist. Bei einer anderen Ausführungsform können sämtliche Kontaktzungen an lediglich einer Seite der Steckerleiterplatte vorgesehen sein. Hierdurch können beispielsweise zwei Platinen nebeneinander, vorzugsweise in einer Ebene, miteinander elektrisch leitend verbunden werden.

Um eine funktionssichere elektrische Verbindung zu erreichen, und/oder um mit einer relativ klein bauenden Steckerleiterplatte möglichst viele Leiterbahnenzweige miteinander in elektrische Verbindung zu bringen, kann vorgesehen sein, dass die Steckerleiterplatte Leiterbahnen auf der Ober- und/oder auf der Unterseite aufweist.

Eine weitere Ausführungsform der Erfindung sieht vor, dass die Breite der Leiterbahnen gleich oder kleiner als die Breite der Kontaktzungen ist. Dabei können die Leiterbahnen auf der Steckerleiterplatte parallel zueinander angeordnet sein. Sämtliche Leiterbahnen sind vorteilhafterweise gegeneinander isoliert, so dass die Steckerleiterplatte keine Schaltungsfunktion aufweist.

Ebenso ist denkbar, dass auf der Steckerleiterplatte elektrische und/oder elektronische Bauteile angeordnet sind. Über diese Bauteile können zusätzliche Verschaltungen vorgesehen werden. Hierdurch kann gegebenenfalls die Anzahl der Bauteile auf den Platinen verringert werden.

Die Kontaktzungen können insbesondere durch Ausschneiden, Austrennen, Ausfräsen oder dergleichen hergestellt werden.

Die eingangs genannte Aufgabe wird außerdem gelöst durch die Verwendung der erfindungsgemäßen Steckerleiterplatte zur leitenden Verbindung von Leiterbahnen wenigstens zweier elektrische und/oder elektronische Bauteile aufweisenden Platten.

Ferner wird die eingangs genannte Aufgabe gelöst durch einen Platinen-Aufbau, der wenigstens zwei elektrische und/oder elektronische Bauteile aufweisende Platinen sowie wenigstens eine erfindungsgemäße Steckerleiterplatte aufweist. Zur Aufnahme der Kontaktzungen der Steckerleiterplatte sind an den Platinen vorteilhafterweise entsprechende Steckeraufnahmen, beispielsweise in Form von Bohrungen, vorgesehen.

Ein vorteilhafter Platinen-Aufbau ergibt sich dann, wenn die wenigstens beiden Platinen wenigstens weitgehend parallel zueinander angeordnet sind. Sind die Platinen übereinander angeordnet, so handelt es sich um sogenannte "Huckepack"-Platinen-Aufbauten. Vorzugsweise ist die Steckerleiterplatte wenigstens weitgehend senkrecht zu den Platinen angeordnet.

Um eine funktionssichere Kontaktierung der Kontaktzungen zu gewährleisten, sind vorteilhafterweise an den Platinen Steckeraufnahmen vorgesehen, in die die Kontaktzungen der Steckerleiterplatte im montierten Zustand eingesteckt sind. Vorzugsweise sind die Kontaktzungen lösbar in die Steckeraufnahmen eingesteckt, wodurch eine leichte Demontage des Aufbaus möglich ist.

Erfindungsgemäß ist weiterhin denkbar, dass zum Beispiel Leiterbahnenvertauschungen über Platinendurchkontaktierungen realisiert werden können, wodurch eine weitere Verdrahtungsebene entsteht.

Weitere vorteilhafte Einzelheiten und Ausgestaltungen der Erfindung sind der folgenden Beschreibung zu entnehmen, in der die Erfindung anhand der in der Zeichnung dargestellten Ausführungsbeispiele näher beschrieben und erläutert ist.

Es zeigen:
- Figur 1: eine erste Ausführungsform einer erfindungsgemäßen Steckerleiterplatte;
- Figur 2: eine zweite Ausführungsform einer erfindungsgemäßen Steckerleiterplatte;
- Figur 3: einen erfindungsgemäßen Platinen-Aufbau; und
- Figur 4: eine dritte Ausführungsform einer erfindungsgemäßen Steckerleiterplatte.

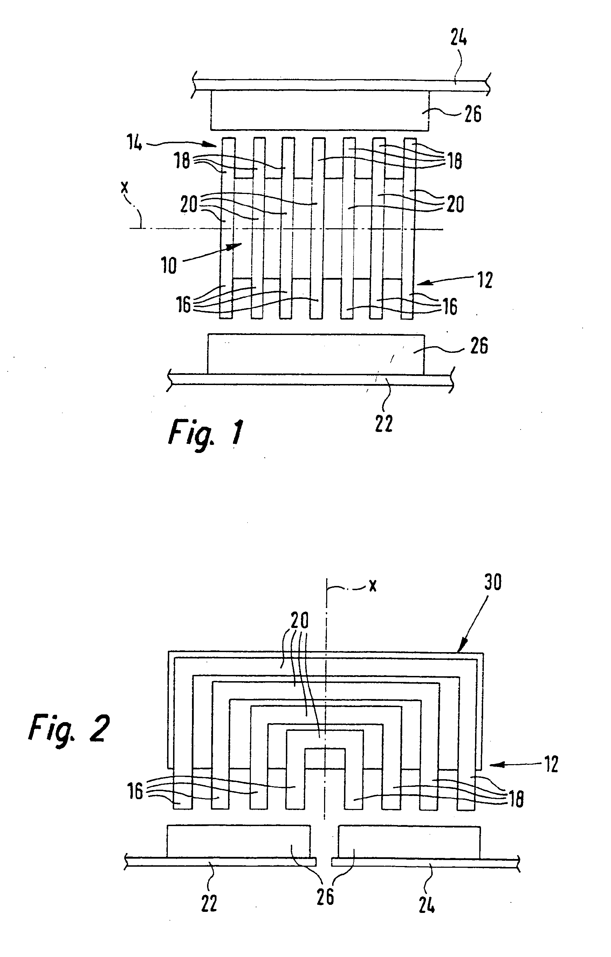

In der Figur 1 ist eine erfindungsgemäße Steckerleiterplatte 10 dargestellt, die an ihren gegenüberliegenden Seiten 12 und 14 einstückig mit der Steckerleiterplatte 10 ausgebildete Kontaktzungen 16 und 18 aufweist. Die Kontaktzungen 16 und 18 weisen einen zylindrischen und rechteckigen Querschnitt auf. Jeweils eine Kontaktzunge 16 ist mit einer ihr gegenüberliegenden Kontaktzunge 18 über eine Leiterbahn 20 elektrisch leitend verbunden. Die einzelnen Leiterbahnen 20 sind parallel zueinander angeordnet. Die Breite der Leiterbahnen 20 entspricht im Wesentlichen der Breite der Kontaktzungen 16, 18. Zur Herstellung der Kontaktzungen 16, 18 wird die Leiterplatte 10 an den zwischen den Kontaktzungen 16, 18 liegenden Stellen ausgeschnitten, insbesondere ausgefräst.

In der Figur 1 sind zwei Platinen 22, 24 angedeutet, auf der in der Figur 1 nicht dargestellte elektrische und elektronische Bauteile vorgesehen sind. Ferner ist auf der Platine 22 und 24 jeweils eine Steckeraufnahme 26 angeordnet, in die die entsprechenden Kontaktzungen 16, 18 einführbar sind.

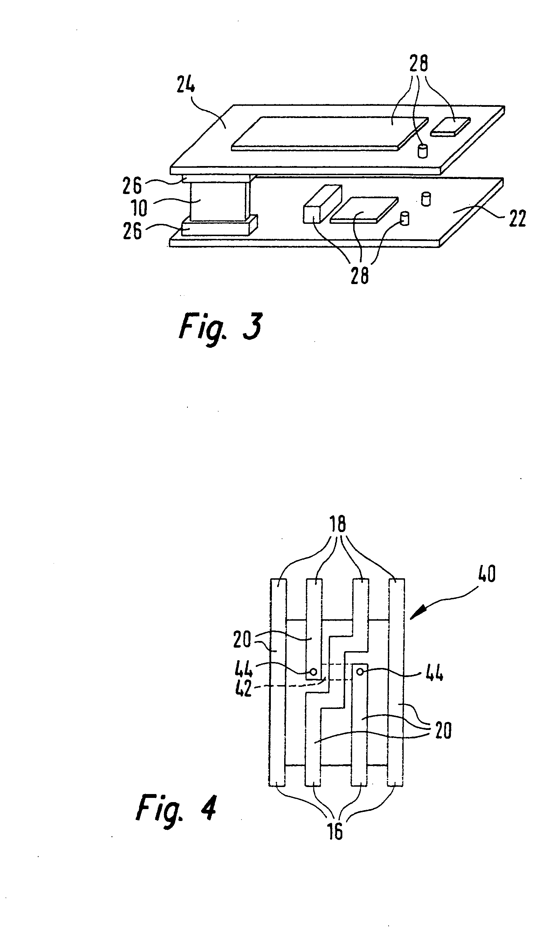

In der Figur 3 ist ein derartiger Platinenaufbau perspektivisch dargestellt. Deutlich zu erkennen sind die beiden Platinen 22, 24 und die Steckerleiterplatte 10. Die Platinen 22, 24 weisen verschiedene elektrische und elektronische Bauteile 28 auf. Die beiden Platinen 22, 24 sind übereinander und parallel zueinander angeordnet.

In der Figur 2 ist eine zweite erfindungsgemäße Steckerleiterplatte 30 dargestellt. Bei dieser Steckerleiterplatte liegen sämtliche Kontaktzungen 16, 18 auf einer Seite der Steckerleiterplatte 30. Auch in'dieser Figur sind zwei Platinen 22, 24 angedeutet, die entsprechende Steckeraufnahmen 26 aufweisen. Im montierten Zustand liegen die beiden Platinen 22, 24 nebeneinander in einer Ebene.

Auf den spiegelsymmetrisch zu ihrer entsprechenden Mittelachse x ausgebildeten Steckerleiterplatten 10 und 30 sind keine elektrischen Schaltungen oder elektrische und/oder elektronischen Bauteile vorgesehen. Erfindungsgemäß ist allerdings denkbar, dass auch auf den Steckerleiterplatten 10, 30 elektrische und/oder elektronische Bauteile vorgesehen sein können, wodurch gegebenenfalls die miteinander zu versteckenden Platinen 22, 24 mit einer geringeren Anzahl von elektronischen Bauteilen 28 auskommen.

In der Figur 4 ist eine weitere erfindungsgemäße Steckerleiterplatte 40 gezeigt, die eine Leiterbahnenvertauschung in Form einer Durchkontaktierung 42 aufweist. Die Durchkontaktierung 42 greift in zwei Befestigungslöcher 44 ein. Durch eine Leiterbahnenvertauschung kann eine größere Flexibilität in der Anordnung der Reihenfolge der Kontaktzungen 16, 18 erreicht werden.

## Patentansprüche

1. Steckerelement (10, 30), insbesondere zur Verbindung von Leiterbahnen wenigstens zweier elektrische und/oder elektronische Bauteile (28) aufweisenden Platinen (22, 24), **dadurch gekennzeichnet, dass** das Steckerelement als Steckerleiterplatte (10, 30) ausgebildet ist, die an wenigstens einer Seite (12, 14) einstückig mit der Steckerleiterplatte (10, 30) ausgebildete Kontaktzungen (16, 18) aufweist.

2. Steckerelement (10, 30) nach Anspruch 1, **dadurch gekennzeichnet, dass** die Kontaktzungen (16, 18) in der Ebene der Steckerleiterplatte (10, 30) liegen.

3. Steckerelement (10, 30) nach Anspruch 1 oder 2, **dadurch gekennzeichnet, dass** die Kontaktzungen (16, 18) zylindrisch sind.

4. Steckerelement (10, 30) nach Anspruch 1, 2 oder 3, **dadurch gekennzeichnet, dass** die Steckerleiterplatte (10) an zwei gegenüberliegenden Seiten Kontaktzungen (16, 18) aufweist.

5. Steckerelement (10, 30) nach einem der vorhergehenden Ansprüche, **dadurch gekennzeichnet, dass** die Kontaktzungen (16, 18) spiegelsymmetrisch zur Mittelachse (x) der Leiterplatte angeordnet sind.

6. Steckerelement (10, 30) nach einem der vorhergehenden Ansprüche, **dadurch gekennzeichnet, dass** die Steckerleiterplatte (10, 30) Leiterbahnen (20) auf der Oberseite und/oder auf der Unterseite aufweist.

7. Steckerelement (10, 30), nach einem der vorhergehenden Ansprüche, **dadurch gekennzeichnet, dass** die Breite der Leiterbahnen (20) gleich oder kleiner als die Breite der Kontaktzungen (16, 18) ist.

8. Steckerelement (10, 30) nach einem der vorhergehenden Ansprüche, **dadurch gekennzeichnet, dass** die Leiterbahnen (20) parallel zueinander verlaufen.

9. Steckerelement (10, 30) nach einem der vorhergehenden Ansprüche, **dadurch gekennzeichnet, dass** die Leiterbahnen (20)gegeneinander isoliert sind.

10. Steckerelement (10, 30) nach einem der vorhergehenden Ansprüche, **dadurch gekennzeichnet, dass** auf der Steckerleiterplatte (10, 30) elektrische und/oder elektronische Bauteile angeordnet sind.

11. Steckerelemente (10, 30) nach einem der vorhergehenden Ansprüche, **dadurch gekennzeichnet, dass** die Kontaktzungen (16, 18) durch ausschneiden, austrennen, ausfräsen oder dergleichen hergestellt sind.

12. Verwendung der Steckerleiterplatte (10, 30) nach einem der vorhergehenden Ansprüche zur leitenden Verbindung von Leiterbahnen wenigstens zweier elektrische und/oder elektronische Bauteile (28) aufweisenden Platinen (22, 24) .

13. Platinen-Aufbau, umfassend wenigstens zwei elektrische und/oder elektronische Bauteile (28) aufweisenden Platinen (22, 24) und eine Steckerleiterplatte (10, 30) nach einem der Ansprüche 1 bis 11.

14. Platinen-Aufbau nach Anspruch 13, **dadurch gekennzeichnet, dass** die wenigstens beiden Platinen (22, 24) wenigstens weitgehend parallel zueinander angeordnet sind.

15. Platinen-Aufbau nach Anspruch 13 oder 14, **dadurch gekennzeichnet, dass** die Steckerleiterplatte (10, 30) wenigstens weitgehend senkrecht zu den Platinen (22, 24) angeordnet ist.

16. Platinen-Aufbau nach Anspruch 13, 14 oder 15, **dadurch gekennzeichnet, dass** die Platinen (22, 24) Steckeraufnahmen (26) aufweisen, in die die Kontaktzungen (16, 18) der Steckerleiterplatte (10, 30) im montierten Zustand eingesteckt sind.
